# EUROPEAN PATENT SPECIFICATION

(11) **EP 3 945 539 B1**
(45) Date of publication and mention of the grant of the patent: **07.06.2023**
(21) Application number: 20188870.8
(22) Date of filing: 31.07.2020
(51) Int. Cl.: H01J 37/08

(54) **A GAS ION GUN**
GASIONENKANONE
PISTOLET À IONS DE GAZ

(43) Date of publication of application: 02.02.2022
(73) Proprietor: Centre National de la Recherche Scientifique, 75016 Paris 16 (FR); Université d'Aix Marseille, 13007 Marseille 7 (FR)
(72) Inventor: SALANÇON, Evelyne, 13009 Marseille (FR); DEGIOVANNI, Alain, 13001 Marseille (FR); LAPENA, Laurent, 13009 Marseille (FR); MORIN, Roger, 13007 Marseille (FR)
(74) Representative: INNOV-GROUP

(56) References cited:
- JP-A- S6 424 340
- EVELYNE SALANÇON ET AL: "Single mineral particle makes an electron point source", JOURNAL OF VACUUM SCIENCE & TECHNOLOGY B: MICROELECTRONICS AND NANOMETER STRUCTURES, vol. 33, no. 3, 27 March 2015 (2015-03-27) , pages 030601-1, XP055726602, 2 Huntington Quadrangle, Melville, NY 11747 ISSN: 2166-2746, DOI: 10.1116/1.4916237

## Description

The invention relates to a gas ion gun.

Such guns are also known as GFIS (Gas Field Ion Source). There exist many applications for such guns. For example, they are used in local abrasion devices or local deposition devices. They are also used for chemical analysis of a sample where the sample is first bombarded by gas ions using a focused ion beam (FIB).

For example, a gas ion gun is disclosed in the following article: E. Salançon et Al: "A new approach to gas field ion sources", Ultramicroscopy 95, pages 183-188, 2003.

JP S-64 24340 A (FUJITSU LTD) discloses an emitter for an electric field ionization type gas ion source.

Gas ion guns should not be confused with electron field emission sources. Electron field emission sources emit electrons which are extracted from a metal electrode. In gas ion gun, on the contrary, the electrode is used to remove electrons from gas atoms or gas molecules and to absorb the removed electrons. In addition, the electrical field necessary to ionize a gas is much higher than the one used to extract electrons. Typically, the electrical field necessary to remove electrons from gas is greater than 10 V/nm. This value should be compared to the 1 V/nm habitually used to extract electrons in conventional electron field emission sources. Finally, the electrode of electron field emission sources is placed in a chamber pressure of which is as low as possible. On the opposite, the electrode of gas ion guns is placed in a chamber where the pressure is much higher because this chamber must contains the gas to be ionized. Due to those differences, teaching given for electron field emission sources is not transposable to gas ion guns without further investigation.

The aim is to propose an improved gas ion gun. The subject of the invention is therefore a gas ion gun according to claim 1.

The invention will be better understood on reading the following description, provided solely by way of non-limiting example and with reference to the drawings, in which:
- figure 1 is a schematic illustration of a gas ion gun,
- figure 2 is an enlarged and schematic view of an electrode used in the gas ion gun of figure 1,
- figure 3 is an enlarged, partial and schematic view of a crystal particle of the electrode of figure 2.

In the figures, the same references are used to denote the same elements.

In the rest of this description, features and functions that are well known to those skilled in the art will not be described in detail.

In the following description, embodiment examples are first described with reference to the figures in a chapter I. Subsequently, other possible alternative embodiments are presented in a chapter II. Finally, the advantages of the disclosed embodiments are discussed in a chapter III.

### Chapter I : Embodiment examples

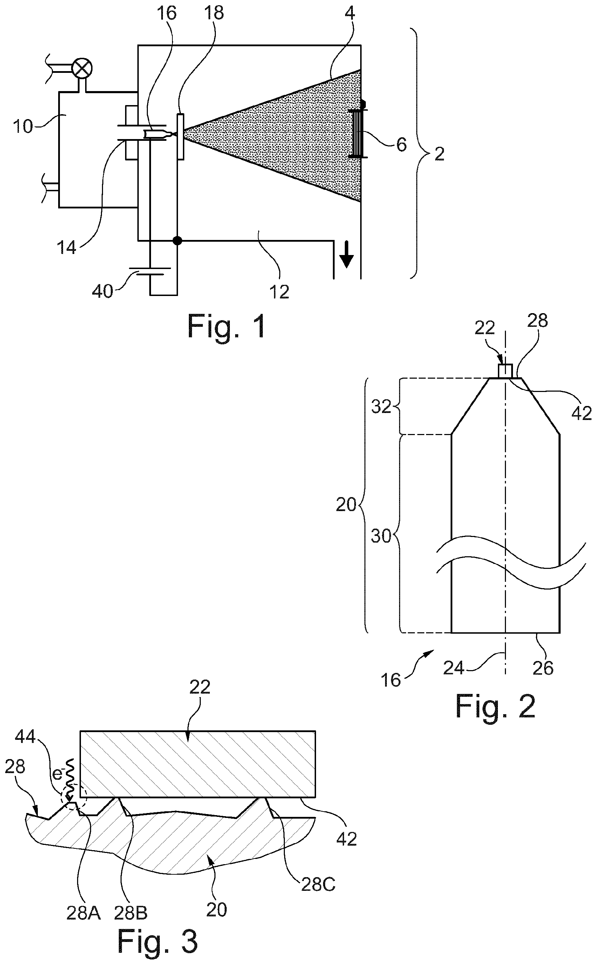

Figure 1 shows a gas field ion gun 2. Gun 2 generates beam 4 of gas ions that irradiates a target 6. Target 6 may be any object to be irradiated with gas ions.

The structure and the method to use this gas field ion gun is very similar to the structure of the gas field ion gun disclosed in the following article : E. Salançon et Al : "A new approach to gas field ion sources", Ultramicroscopy 95, pages 183-188, 2003. Accordingly, only the differences between gun 2 and this known gas field ion gun are described in detail here-below.

Gun 2 comprises :
- a rough pressure chamber 10,
- a low pressure chamber 12,
- a tube 14 that fluidly connects chamber 10 to chamber 12,
- an anode electrode 16 mainly received inside tube 14, and
- an cathode 18.

Chamber 10 comprises the gas to be ionized. The gas may be any gas that can be ionized like hydrogen, helium, neon or similar. The pressure of the gas in chamber 10 is typically greater than 10⁻² mbar (10⁻³ kPa). Usually, the pressure in chamber 10 is smaller than 1 bar (100 kPa).

Beam 4 is created in chamber 12 and then propagates in chamber 12 till target 6. In this embodiment, chamber 12 is designed to limit the number of collision between created gas ions and other particles before reaching target 6. Thus, the pressure in chamber 12 is much lower than in chamber 10. For example, the pressure in chamber 12 is 10⁴ or 10⁶ times lower than in chamber 10. Accordingly, the pressure in chamber 12 is usually between 10⁻⁶ mbar (10⁻⁷ kPa) and 10⁻² mbar (10⁻³ kPa).

Tube 14 is used to introduce the gas from chamber 10 into chamber 12. For this reason, it has one extremity housed within chamber 10 and its opposite extremity housed within chamber 12. Tube 14 is the only fluid connection between chambers 10 and 12. Tube 14 is an allow tube.

Tube 14 is made of a hollow insulating part and of a hollow conductive part. The insulating part is housed within chamber 10. For example, the insulating part is made of ceramic. The conductive part is received within chamber 12. The conductive part is fluidly connected to the insulating part through a conductive sleeve. Electrode 16 is only received inside the conductive part of tube 14. To this end, the internal diameter of the conductive part of tube 14 is greater than the diameter of electrode 16. For example, the conductive part is made of stainless steel.

The gas flow between chambers 10 and 12 depends on the internal diameter of the conductive part of tube 14 and of the diameter of electrode 16.

For example, once electrode 16 is housed inside tube 14, the distance between the outer surface of electrode 16 and the internal surface of the conductive part of tube 14 is smaller than 50 µm. Here, the internal diameter of the conductive part of tube 14 is equal to 150 µm.

For example, in this embodiment, a pump sucks the gas in chamber 12 at a predetermined and constant speed. In such a situation, the flow of gas between chambers 10 and 12 can be set by adjusting the gas pressure in chamber 10.

Only a tip of electrode 16 emerges from the distal extremity of tube 14 so that the tip of electrode 16 directly faces cathode 18. The part of electrode 16 housed within tube 14 is electrically connected to a positive terminal of a voltage supply 40. For example, electrode 16 is connected to voltage supply 40 by a wire that goes through the connecting sleeve between the insulating and conductive parts of tube 14.

Cathode 18 is electrically biased versus electrode 16 to create an electrical field between the tip of electrode 16 and cathode 18 able to ionize the gas injected into chamber 12 through tube 14. To this end, cathode 18 is electrically connected to a negative terminal of voltage supply 40.

Cathode 18 can be crossed by the generated gas ions. To this end, it at least comprises one aperture in front of the tip of electrode 16. In this embodiment, cathode 18 is a grid known as an "extracting grid".

The distance between the tip of electrode 16 and cathode 18 is smaller than 1 mm. However, this distance should not be to small in order to avoid crashing the tip of electrode 16 into cathode 18. Therefore, usually, this distance is greater than 1 µm.

Voltage supply 40 creates a potential difference between electrode 16 and cathode 18. The generated potential difference is such that the magnitude of the electric field at the tip of electrode 16 is high enough to ionize the gas. Typically, at the tip of electrode 16 the magnitude of the electrical field is greater than 5 V/nm. Here, in the invention, the difference of potentials between the positive terminal and the negative terminal of voltage supply 40 is such that the magnitude of the electrical field is greater than 10 V/nm at the tip of electrode 16.

Note that, due to the fact that electrode 16 is housed in tube 14, the gas is injected in chamber 12 at an emplacement very close to the tip of electrode 16. It creates a local pressure of gas at the emplacement of the tip of electrode 16 which is greater than the average pressure in chamber 12. Accordingly, gun 2 is able to work with a local pressure in the vicinity of the electrode tip which is much higher than the pressure encountered in other gas ion gun having a different configuration. This makes gun 2 easier to manufacture and more efficient.

As shown in Figure 2, electrode 16 comprises a wire 20 and a crystal particle 22.

Wire 20 catches the electrons which are removed from the gas. To this end, typically, wire 20 is made of a material the work function of which is smaller than 6 eV or 5 eV. In this embodiment, wire 20 is made of an electrically conductive material. In this text, an electrically conductive material is a material having an electrical conductivity at 20°C greater than 10⁶ S/m or 10⁷ S/m.

Here, wire 20 is made of a metallic core. For example, the metallic core is made of polycrystalline Tungsten (W). In addition, the whole metallic core of wire 20 or at least the tip of wire 20 is coated with a noble metal in order to improve the resistance of wire 20 to chemical reactions that lead to corrosion. Here the tip is coated with a thin layer of Palladium (Pd). For example, the thickness of this coating is smaller than 1 µm.

Wire 20 extends, along a longitudinal axis 24, from a proximal end 26 to a flatten distal end 28. From the proximal end 26 to the distal end 28, it successively comprises a main cylindrical part 30 in direct mechanical connection with a truncated cone 32. The wavy lines in Fig. 2 indicates that a portion of cylindrical part 30 has not been shown.

Here, the cross section of cylindrical part 30 is a circle of constant diameter. The diameter D₃₀ of part 30 is small, that is smaller than 500 µm. Generally, diameter D₃₀ is also greater than 5 µm. In this embodiment, the diameter D₃₀ is equal to 125 µm. All the cylindrical part 30 or most of the cylindrical part 30 is housed within tube 14.

Part 30 is directly electrically connected to the first positive terminal of the voltage supply 40.

Flatten end 28 is the extremity surface of wire 20. Flatten end 28 mainly extends in a plan perpendicular to axis 24. In this embodiment, flatten end 28 is essentially circular.

Truncated cone 32 smouthly reduces the diameter of wire 20 from diameter D₃₀ to a diameter D₂₈. Diameter D₂₈ is the diameter of the flatten end 28. Diameter D₂₈ is two or three times smaller than diameter D₃₀ and, preferably, ten times smaller than diameter D₃₀. Diameter D₂₈ is also not to small in order to accommodate crystal particle 22. Typically, diameter D₂₈ is greater than 500 nm. Here, diameter D₂₈ is equal to 10 µm.

The high of truncated cone 32 is greater than D₃₀/2. Accordingly, here, the high of truncated cone 32 is greater than 62,5 µm. Most of the time, the high of truncated cone 32 is smaller than 10D₃₀.

Such a wire 20 can be manufactured by electrolytic etching or electrolysis etching process like the one disclosed in WO2011124617A1.

Wire 20 is fixed inside tube 14 such that only truncated cone 32 emerges outside the distal extremity of tube 14. Preferably, only truncated cone 32 extends outside tube 14.

Crystal particle 22 is directly deposited on flatten end 28. Particle 22 has a lower face 42 directly in mechanical contact with flatten end 28.

Preferably, crystal particle 22 is closed to axis 24. In practice, the orthogonal projection of crystal particle 22 on a plan perpendicular to axis 24 is entirely included within the orthogonal projection of the flatten end 28 on the same plan.

The relative permittivity of crystal particle 22 is greater than one, preferably, can be greater than five. Here, "relative permittivity" refers to the static relative permittivity. In this example, the crystal particle is a diamond having a relative permittivity greater or equal to eight.

Accordingly, the crystal particle is an insulating material the electrical conductivity of which is very low. Typically, the electrical conductivity of crystal particle 22 is lower than 10⁻¹¹ S/m at 20°C.

The size of crystal particle 22 is very small. Here, it means that the length L₂₂ and the width W₂₂ of the crystal particle 22 are smaller than 100 nm. The length L₂₂ and width W₂₂ are also greater than 5 nm. The high H₂₂ of the crystal particle is smaller than 40 nm. High H₂₂ is also generally greater than 1 nm. Here, for example, length L₂₂, width W₂₂ and high H₂₂ are equal to, respectively, 50 nm, 50 nm and 10 nm. In most of the case, the crystal particle is not a perfect parallelepiped. Thus, in this text, the length, the width and the high of the crystal particle are equal, respectively, to the length, the width and the high of the smallest parallelepided that entirely contains the crystal particle. The smallest parallelepiped is the parallelepiped having the smallest volume.

The length and the width of the crystal particle are lying in a plane mainly parallel to the flatten end. Thus, the high of the crystal particle is mainly parallel to the wire axis 24.

There is only one crystal particle 22 on top of flatten end 28. To this end, for example, the crystal particle 22 is deposited on flatten end 28 using a glass capillary with a tip aperture diameter of 10 µm or less depending on the crystal particles size. More precisely, a crystal's powder is first dispersed under ultra-sound in deionized water. The capillary is filled with the dispersed crystal water. A slight pressure is applied to the wide end of the capillary to form a small drop at the tip aperture. Then, the flatten surface 28 is immersed in this small drop. When the flatten end 28 is pulled out from the small drop, some water with a very limited number of crystal particles remains on the flatten end 28. The density of crystal particles 22 in the deionized water is adjusted to obtain at least one crystal particle so deposited on the flatten end 28. For example, 1 mg of crystal particles 22 are dispersed in 10 mL of deionized water. Subsequently, a microscope can be used to verify the number of crystal particles 22 deposited on flatten end 28. The microscope is, for example, a scanning electron microscope. Here, only the manufactured wires having only one single crystal particle 22 on flatten end 28 are selected to be used as electrode 16.

Fig. 3 shows in more detail a portion of crystal 22 on top of flatten end 28. The roughness of flatten end 28 is much higher than the roughness of the lower face 42 of crystal particle 22. Typically, the roughness of flatten end 28 is ten times greater than the roughness of lower face 42. For example, roughness of surface 28 and 42 can be measured or estimated using the Ra roughness. The low roughness of particle 22 is due to the fact that particle 22 has the structure of a single crystal which is highly ordered and its lattice is continuous and unbroken. On the contrary, wire 20 is made from a non-cristalline material or from a polycristalline material. Thus, its roughness is much higher than the roughness of a single crystal.

Accordingly, as schematically shown in Fig. 3, flatten end 28 comprises picks that extend toward cathode 18.

Lower face 42 of crystal particle 22 rests on the tips of the highest picks situated just underneath. Picks 28B and 28C are illustration of such picks.

Since the size of crystal particle 22 is very small, it is submitted that there also exists only one pick which is :
- not underneath crystal particle 22,
- the tip of which is not in direct contact with crystal particle 22, and
- the tip of which is the closest from the crystal particle 22.
An illustration of such a pick is shown under the number reference 28A in Fig. 3.

Typically, the distance between the tip of pick 28A and the closest edge of crystal particle 22 is as small as a few nanometers. For example, this distance is smaller than 5 nm.

Presently, it is submitted that the highest magnitude of the electrical field lies between pick 28A and the edge of crystal particle 22 which is the closest of the tip of pick 28A. Thus, the ionization of the gas only takes place at this emplacement. In Fig. 3, such an ionization is illustrated by the symbol "e⁻ " and a wavy arrow that points toward the tip of pick 22A and that illustrates the path of electron "e⁻ ".

More precisely, the operation of electrode 16 when a potential difference is applied by voltage supply 40 is explained as follows. Subjected to an electrical field and due to the crystal particle 22, the magnitude of the electrical field is exalted in a zone 44 (Fig. 3) of the tip of electrode 16. It is submitted that zone 44 is situated between the tip of pick 28A and a lower edge of crystal particle 22. In zone 44 the magnitude of the electrical field is high enough to trigger the gas ionization. Here, voltage supply 40 is set so that the magnitude of the electrical field between electrode 16 and cathode 18 is such that :
- the magnitude of electrical field in zone 44 is greater than 10V/nm, and
- the magnitude of the electrical field outside zone 44 is not enough to ionize the gas.

For example, outside zone 44, the electrical field is smaller than 10 V/µm when the potential difference between anode 16 and cathode 18 is equal or smaller than 5kV.

Thus, the ionization of the gas only takes place in zone 44. It means that the emitting surface of electrode 16 is very small. Accordingly, electrode 16 has an improved brightness. It is recalled that the "brightness" B of gas ion gun is defined by the following relationship : B = I/(ΩS), where :
- I is the intensity of the gas ion beam in Ampere,
- Ω is the solid angle of the gas ion beam, and
- S is the surface of the emitting electrode.

In addition, it has been observed that the lifetime of electrode 16 is improved. The improved lifetime of electrode 16 is explained by the fact that pick 28A is at least partially protected by crystal particle 22.

### Chapter II : Other embodiments

### Alternative embodiments of the electrode :

Other crystal particles than diamond may be used. For example, crystal particles of the following material can be used : celadonite particle, kaolinite, talc.

What is important is that the electrical conductivity of wire 20 is greater than the electrical conductivity of the crystal particle. According to the invention, the electrical conductivity of wire 20 is ten times greater, typically ten times to 10⁴ times greater than the electrical conductivity of the crystal particle. Accordingly, provided that such a condition is satisfied, the crystal particle may also be made from a semiconductor material.

While, in most situations, the crystal particle should be very small, in some other situation, the size of the crystal particle may be chosen bigger. Typically, the length and width of the crystal particle may be as big as 1 µm. The high of the crystal particle may be as big as 100 nm.

For some application, it may be acceptable to have several crystal particles 22 deposited on flatten end 28. For example, the number of crystal particles 22 on the flatten end 28 is equal or greater than five.

Truncated cone 32 may be omitted. In such a case, there exists an abrupt transition between cylindrical part 30 and flatten end 28. For example, the truncated cone is omitted when diameter D₃₀ of the conductive wire is small, that is for example smaller than 30 µm. Such a conductive wire having a small diameter may be a carbon fiber. For example, the diameter of the carbon fiber is 10 µm or less.

Other conductive materials are possible for wire 20. For example, wire 20 can be made of other metal like tungsten, copper and, preferably, of noble metal like Iridium (Ir) or Palladium (Pd). The coating of the core of the wire may be omitted in the simplest embodiment. The conductive material may also not be a metal. For example, the wire can be a carbon fiber.

Wire 20 is not necessarily made of conductive material. It can also be made of semiconductor material like silicon. In such a case, its electrical conductivity at 20°C is greater than 10⁻⁵ S/m.

The cross section of cylindrical part 30 may be different from a circle. For example, the cross section can be rectangular. When the cross section of part 30 is not a circle, the diameter of the cross section is defined as being equal to the hydraulic diameter of this cross section.

Similarly, the flatten end is not necessarily a disk surface. It can be rectangular or may have any other appropriate forms. For other forms than a disk, the term "diameter" means "hydraulic diameter".

### Other alternatives :

Other embodiment of the cathode are possible. For example, the cathode can be a conductive plate having a single hole in front of the tip.

It is not mandatory that the gas to be ionized be made only of a single species of gas atoms. The gas to be ionized may also be a mixture of different gas atom species like helium and hydrogen. It can also contain gaseous molecules like water vapor or other gaseous molecules that can be ionized.

Other embodiments of gun 2 are possible. For example, in an alternative embodiment, in addition, electrode 16 is cooled down so that the gas condenses on its tip.

Electrode 16 can be used in another embodiment of a gas ion gun. For example, electrode 16 is placed within a chamber comprising a low pressure of gas. Electrode 16 is cooled down so that the gas condenses on the tip of electrode 16. The condensed gas on the tip of electrode 16 is then ionized. In such an embodiment, chamber 10 is omitted. It is also not mandatory to house electrode 16 in a tube like tube 14.

### Chapter III : Advantages

Due to the use of the crystal particle on the flatten distal end of wire 20, the lifetime of the electrode is increased compared to the lifetime of a conventional electrode used in the same conditions.

It has also been observed that gun 2 starts to emit gas ions for a lower potential difference between cathode 18 and electrode 16 than if a conventional electrode was used.

In addition, the brightness of gun 2 is improved in comparison to similar gas ion guns deprived of crystal particle at the end of the conductive wire. This is explained by the fact that there is only a very limited number of picks of flatten end 28 that can absorb electrons from the gas.

The applicant is aware of the following article : E. Salançon et AL : "Single mineral particle makes an electron point source", Journal of Vaccuum Sciense & Technology, B 33, 030601 (2015). This article is referred herein as "Article2015". Article2015 discloses an electron field emission sources having an electrode which contains a crystal particle. However, as explained in the introduction of the present text, the way of using electrodes in gas ion guns is very different from the way of using electrodes in electron field emission sources. Thus, the skill man cannot straightforwardly transpose a teaching given in the context of electron field emission sources to gas ion guns. In addition, Article2015, as well as all the other articles of the same authors, clearly recites that :
- there exists a Fowler-Nordheim regime at low voltage where the beam intensity strongly increases with the potential difference applied, and
- at higher voltage, a saturation regime where the beam intensity increases less strongly with the potential difference.
   Accordingly, the electrode disclosed in Article2015 has only being used in the Fowler-Nordheim regime because the saturation regime is less efficient. For this reason, up to now, the electrode of Article2015 was deemed to be usable only in electron field emission sources and not in gas ion guns because in gas ion gun it is necessary to use electric field which are ten times greater than the one used in electron field emission sources. In fact, without further knowledge, it could be expected from the prior art publication that the saturation regime would occur when using the electrode of Article2015 in a gas ion gun because a higher potential difference is required to remove electrons from gas. However, what is revealed in this application, is that such an electrode is also suitable for gas ion guns.

The truncated cone allows to reduce the solid angle of the ion beam. Thus, the brightness is improved.

Using a crystal, length and width of which are smaller than 100 nm, produces an electrode comprising a single pick that ionizes the gas. Therefore the emitting surface of the electrode is reduced and the brightness is improved.

Using a diamond as the crystal deposited on the flatten distal end of the electrode improves the brightness.

Bringing the gas through a tube in which is housed the conductive wire further increases the brightness of the gun.

## Claims

1. A gas ion gun comprising :
- a main chamber (12) in which is introduced a gas to be ionized,
- an anode electrode (16) to remove electrons from the gas in order to create gas ions, the anode electrode comprising a wire (20) made of an electrical conductive material or of a semiconductor material, the wire extending along a longitudinal axis from a proximal end (26) to a flatten distal end (28) and the flatten distal end being housed inside the main chamber,
- a cathode (18) to create an ionizing electric field which is greater than 10V/nm in a region near the flatten distal end of the wire,
**characterized in that** the anode electrode (16) further comprises a crystal particle (22) directly deposited on the flatten distal end (28), the electrical conductivity of the crystal particle being ten times smaller than the electrical conductivity of the wire.

2. The gas ion gun according to claim 1, wherein the anode electrode (16) only comprise one single crystal particle (22) directly deposited on the flatten distal end.

3. The gas ion gun according to anyone of the preceding claims, wherein the wire comprises a truncated cone (32), cross-section of which is decreasing till the flatten distal end (28).

4. The gas ion gun according to anyone of the preceding claims, wherein :
- the length and the width of the crystal particle (22) are less than 100 nm and the high of the crystal particle is less than 50 nm, the width, the length and the high of the crystal particle being equal to, respectively, the width, the length and the high of the smallest parallelepiped that entirely contains the crystal particle, the smallest parallelepiped meaning the parallelepiped having the smallest volume, and
- the length and the width of the crystal particle being parallel to the flatten end.

5. The gas ion gun according to anyone of the preceding claims, wherein the crystal particle (22) is a diamond.

6. The gas ion gun according to anyone of the preceding claims, wherein the gas ion gun comprises a voltage supply (40) electrically connected to the cathode and the anode electrode, and the potential difference generated by the voltage supply between the cathode and the anode electrode is adapted to have only one single zone (44) between a pick (28A) of the flatten end and an edge of the crystal particle (22) in which the gas ionization takes place.

7. The gas ion gun according to anyone of the preceding claims, wherein :
- the gun comprises a tube (24) that extends from a proximal extremity to a distal extremity, most of the wire (20) being housed within this tube and the distal flatten end of which emerges from the distal extremity of the tube,
- a rough pressure chamber (10) configured to contain a high pressure of the gas to be ionized, the tube proximal extremity being placed inside this rough pressure chamber,
- the tube distal extremity being place inside this main chamber (12) so that the main chamber (12) is only fluidly connected to the rough pressure chamber (10) through the tube,
- the cathode (18) being housed within the main chamber.

8. The gas ion gun according to anyone of the preceding claims, wherein the wire (20) has a diameter between 5 µm and 500 µm.

9. The gas ion gun according to anyone of the preceding claims, wherein the wire is made of at least one electrically conductive material.

10. The gas ion gun according to anyone of the preceding claims, wherein the crystal particle (22) has an inferior face (42) in contact with the flatten end (28), and the roughness of the flatten end is at least ten time greater than the roughness of the inferior face.

11. The gas gun according to anyone of the preceding claims, wherein the electrical conductivity of the crystal particle is lower than 10⁻¹¹ S/m.

## Patentansprüche

1. Gasionenkanone, umfassend:
- eine Hauptkammer (12), in die ein zu ionisierendes Gas eingeleitet wird,
- eine Anodenelektrode (16) zum Entfernen von Elektronen aus dem Gas, um Gasionen zu erzeugen, wobei die Anodenelektrode einen Draht (20) umfasst, der aus einem elektrisch leitenden Material oder aus einem Halbleitermaterial hergestellt ist, wobei der Draht sich entlang einer Längsachse von einem proximalen Ende (26) zu einem flachen distalen Ende (28) erstreckt und das flache distale Ende im Inneren der Hauptkammer aufgenommen ist,
- eine Kathode (18) zum Erzeugen eines ionisierenden elektrischen Feldes, das stärker als 10 V/nm ist, in einem Bereich nahe dem flachen distalen Ende des Drahtes,
**dadurch gekennzeichnet, dass** die Anodenelektrode (16) ferner ein Kristallpartikel (22) umfasst, das direkt auf das flache distale Ende (28) aufgebracht ist, wobei die elektrische Leitfähigkeit des Kristallpartikels zehn Mal kleiner ist als die elektrische Leitfähigkeit des Drahtes.

2. Gasionenkanone nach Anspruch 1, wobei die Anodenelektrode (16) nur ein einziges Kristallpartikel (22) umfasst, das direkt auf das flache distale Ende aufgebracht ist.

3. Gasionenkanone nach einem der vorangehenden Ansprüche, wobei der Draht einen Kegelstumpf (32) umfasst, dessen Querschnitt sich zu dem flachen distalen Ende (28) hin verkleinert.

4. Gasionenkanone nach einem der vorangehenden Ansprüche, wobei:
- die Länge und die Breite des Kristallpartikels (22) weniger als 100 nm betragen und die Höhe des Kristallpartikels weniger als 50 nm beträgt, wobei die Breite, die Länge und die Höhe des Kristallpartikels entsprechend gleich der Breite, der Länge und der Höhe des kleinsten Parallelepipeds sind, welches das Kristallpartikel vollständig enthält, wobei das kleinste Parallelepiped das Parallelepiped mit dem kleinsten Volumen meint, und
- die Länge und die Breite des Kristallpartikels parallel zu dem flachen Ende sind.

5. Gasionenkanone nach einem der vorangehenden Ansprüche, wobei das Kristallpartikel (22) ein Diamant ist.

6. Gasionenkanone nach einem der vorangehenden Ansprüche, wobei die Gasionenkanone eine Spannungsversorgung (40) umfasst, die elektrisch mit der Kathode und der Anodenelektrode verbunden ist, und die Potenzialdifferenz, die durch die Spannungsversorgung zwischen der Kathode und der Anodenelektrode erzeugt wird, so angepasst ist, dass es nur eine einzige Zone (44) zwischen einer Nase (28A) des flachen Endes und einem Rand des Kristallpartikels (22) gibt, in der die Gasionisation stattfindet.

7. Gasionenkanone nach einem der vorangehenden Ansprüche, wobei:
- die Kanone eine Röhre (24) umfasst, die sich von einem proximalen Endabschnitt zu einem distalen Endabschnitt erstreckt, wobei ein Großteil des Drahtes (20) innerhalb dieser Röhre aufgenommen ist und das distale flache Ende desselben aus dem distalen Endabschnitt der Röhre heraussteht,
- eine Rohdruckkammer (10) dazu ausgestaltet ist, einen hohen Druck des zu ionisierenden Gases zu enthalten, wobei der proximale Endabschnitt der Röhre im Inneren dieser Rohdruckkammer angeordnet ist,
- der distale Endabschnitt der Röhre im Inneren der Hauptkammer (12) angeordnet ist, sodass die Hauptkammer (12) nur über die Röhre fließfähig mit der Rohdruckkammer (10) verbunden ist,
- die Kathode (18) innerhalb der Hauptkammer aufgenommen ist.

8. Gasionenkanone nach einem der vorangehenden Ansprüche, wobei der Draht (20) einen Durchmesser zwischen 5 µm und 500 µm aufweist.

9. Gasionenkanone nach einem der vorangehenden Ansprüche, wobei der Draht aus wenigstens einem elektrisch leitenden Material hergestellt ist.

10. Gasionenkanone nach einem der vorangehenden Ansprüche, wobei das Kristallpartikel (22) eine Unterseitenfläche (42) aufweist, die mit dem flachen Ende (28) in Kontakt steht, und die Rauheit des flachen Endes wenigstens zehn Mal größer ist als die Rauheit der Unterseitenfläche.

11. Gaskanone nach einem der vorangehenden Ansprüche, wobei die elektrische Leitfähigkeit des Kristallpartikels weniger als 10⁻¹¹ S/m beträgt.

## Revendications

1. Canon à ions gazeux comprenant :
- une chambre principale (12) dans laquelle est introduit un gaz devant être ionisé,
- une électrode anodique (16) pour retirer des électrons du gaz afin de créer des ions gazeux, l'électrode anodique comprenant un fil (20) constitué d'un matériau conducteur électrique ou d'un matériau semi-conducteur, le fil s'étendant le long d'un axe longitudinal depuis une extrémité proximale (26) jusqu'à une extrémité distale aplatie (28) et l'extrémité distale aplatie étant logée à l'intérieur de la chambre principale,
- une cathode (18) pour créer un champ électrique ionisant qui est supérieur à 10 V/ nm dans une région proche de l'extrémité distale aplatie du fil,
**caractérisé en ce que** l'électrode anodique (16) comprend en outre une particule de cristal (22) directement déposée sur l'extrémité distale aplatie (28), la conductivité électrique de la particule de cristal étant dix fois inférieure à la conductivité électrique du fil.

2. Canon à ions gazeux selon la revendication 1, dans lequel l'électrode anodique (16) ne comprend qu'une seule particule de cristal (22) directement déposée sur l'extrémité distale aplatie.

3. Canon à ions gazeux selon l'une quelconque des revendications précédentes, dans lequel le fil comprend un cône tronqué (32), dont la section transversale diminue jusqu'à l'extrémité distale aplatie (28).

4. Canon à ions gazeux selon l'une quelconque des revendications précédentes, dans lequel :
- la longueur et la largeur de la particule de cristal (22) sont inférieures à 100 nm et la hauteur de la particule de cristal est inférieure à 50 nm, la largeur, la longueur et la hauteur de la particule de cristal étant respectivement égales à la largeur, la longueur et la hauteur du plus petit parallélépipède qui contient entièrement la particule de cristal, le plus petit parallélépipède signifiant le parallélépipède ayant le plus petit volume, et
- la longueur et la largeur de la particule de cristal sont parallèles à l'extrémité aplatie.

5. Canon à ions gazeux selon l'une quelconque des revendications précédentes, dans lequel la particule de cristal (22) est un diamant.

6. Canon à ions gazeux selon l'une quelconque des revendications précédentes, le canon à ions gazeux comprenant une source de tension (40) reliée électriquement à la cathode et l'électrode anodique, et la différence de potentiel générée par la source de tension entre la cathode et l'électrode anodique étant adaptée pour n'avoir qu'une seule zone (44) entre un pic (28A) de l'extrémité aplatie et un bord de la particule de cristal (22) dans laquelle l'ionisation du gaz a lieu.

7. Canon à ions gazeux selon l'une quelconque des revendications précédentes, dans lequel :
- le canon comprend un tube (24) qui s'étend depuis une extrémité proximale jusqu'à une extrémité distale, la plus grande partie du fil (20) étant logée à l'intérieur de ce tube et l'extrémité distale aplatie de celui-ci sortant de l'extrémité distale du tube,
- une chambre à haute pression (10) configurée pour contenir une pression élevée du gaz devant être ionisé, l'extrémité proximale du tube étant placée à l'intérieur de cette chambre à haute pression,
- l'extrémité distale du tube étant placée à l'intérieur de cette chambre principale (12) de telle sorte que la chambre principale (12) est uniquement raccordée fluidiquement à la chambre à haute pression (10) par le tube,
- la cathode (18) étant logée à l'intérieur de la chambre principale.

8. Canon à ions gazeux selon l'une quelconque des revendications précédentes, dans lequel le fil (20) a un diamètre compris entre 5 µm et 500 µm.

9. Canon à ions gazeux selon l'une quelconque des revendications précédentes, dans lequel le fil est constitué d'au moins un matériau électriquement conducteur.

10. Canon à ions gazeux selon l'une quelconque des revendications précédentes, dans lequel la particule de cristal (22) a une face inférieure (42) en contact avec l'extrémité aplatie (28), et la rugosité de l'extrémité aplatie est au moins dix fois supérieure à la rugosité de la face inférieure.

11. Canon à gaz selon l'une quelconque des revendications précédentes, dans lequel la conductivité électrique de la particule de cristal est inférieure à 10⁻¹¹ S/m.
